Europäisches Patentamt

European Patent Office

Office européen des brevets

(19)

(11) Veröffentlichungsnummer: **0 201 092 B1**

(12) **EUROPÄISCHE PATENTSCHRIFT**

(45) Veröffentlichungstag der Patentschrift: **30.10.91**

(51) Int. Cl.⁵: **H03D 3/00**, H04B 1/30, H03H 19/00

(21) Anmeldenummer: **86106221.4**

(22) Anmeldetag: **06.05.86**

(54) **Funkempfänger.**

(30) Priorität: **08.05.85 DE 3516492**

(43) Veröffentlichungstag der Anmeldung:
**17.12.86 Patentblatt 86/46**

(45) Bekanntmachung des Hinweises auf die
Patenterteilung:
**30.10.91 Patentblatt 91/44**

(84) Benannte Vertragsstaaten:
**AT BE CH DE FR GB IT LI LU NL SE**

(56) Entgegenhaltungen:
**EP-A- 0 185 416**
**FR-E- 85 134**
**US-A- 3 979 684**

**THE RADIO AND ELECTRONIC ENGINEER,
Band 43, Nr. 7, Juli 1973, Seiten 442-446,
London, GB; S.R. AL-ARAJI et al.: "A direct
conversion v.h.f. receiver"**

(73) Patentinhaber: **Standard Elektrik Lorenz Aktiengesellschaft
Lorenzstrasse 10
W-7000 Stuttgart 40(DE)**

(84) Benannte Vertragsstaaten:

**BE CH DE IT LI LU NL SE AT**

Patentinhaber: **ALCATEL N.V.
Strawinskylaan 537 (World Trade Center)
NL-1077 XX Amsterdam(NL)**

(84) Benannte Vertragsstaaten:
**FR GB**

(72) Erfinder: **Rother, Dietrich, Dr.
Häldenstrasse 81
W-7146 Tamm(DE)**
Erfinder: **Wiechert, Dieter
Lindenstrasse 65
W-7540 Neuenbürg-Arnbach(DE)**
Erfinder: **Moster, Manfred
Nelkenstrasse 12
W-7532 Niefern(DE)**

(74) Vertreter: **Graf, Georg Hugo, Dipl.-Ing. et al
Standard Elektrik Lorenz AG Patent- und Lizenzwesen Postfach 30 09 29
W-7000 Stuttgart 30(DE)**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung betrifft einen Empfänger gemäß den Oberbegriffen der beiden nebengeordneten Ansprüche 1 oder 2. Aus der DE-A-26 45 950.7 ist für frequenzmodulierte Signale ein derartiger Empfänger bekannt. Die Unterdrückung von Störsignalen und die Trennschärfe des Empfängers ist im wesentlichen nur von der Qualität der Tiefpässe abhängig.

Es ist die Aufgabe der Erfindung, einen Empfänger nach dem Null-ZF-Prinzip anzugeben mit gegenüber dem Stand der Technik verbesserter Störsignalunterdrückung und Trennschärfe.

Die Lösung der Aufgabe erfolgt mit den in den Ansprüchen 1 oder 2 angegebenen Mitteln. Weitere Ausgestaltungen sind in den Unteransprüchen enthalten.

Der neue Empfänger benötigt kein auf verschiedene Empfangsfrequenzen abstimmbares Vorselektionsfilter. Er ist für mehrere Modulationsarten, beispielsweise FM, PM oder AM, geeignet. Er wird anhand zweier Ausführungsbeispiele beschrieben.

Es zeigt:

Fig. 1    ein erstes Blockschaltbild des Empfängers,

Fig. 2    ein zweites Blockschaltbild des Empfängers.

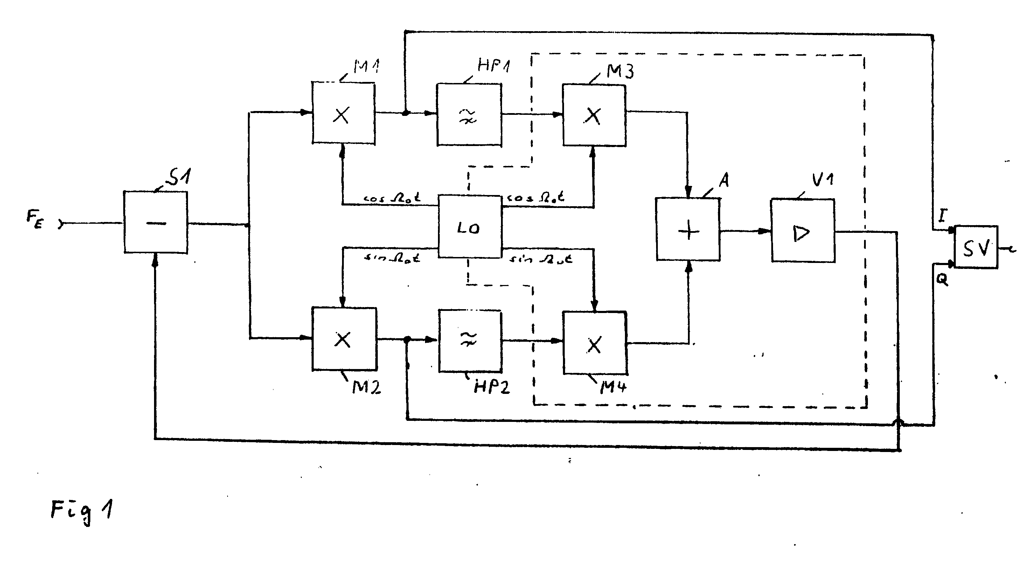

Das erste Ausführungsbeispiel des Empfängers enthält gemäß Fig. 1 einen Subtrahierer S1, vier Mischer M1 bis M4, einen Oszillator LO, einen Addierer A, einen Verstärker V1 und eine Signalverarbeitungseinrichtung SV. Jeweils ein Eingang jedes Mischers ist mit dem Oszillator LO verbunden. Der andere Eingang der Mischer M1 und M2 ist mit dem Ausgang des Subtrahierers S1 verbunden. Den Mischern M1 und M2 ist je ein Hochpaßfilter HP1 oder HP2 nachgeschaltet. Der Ausgang des Hochpaßfilters HP1 ist mit dem Eingang des Mischers M3 und der des Hochpaßfilters HP2 mit dem des Mischers M4 verbunden. Die Ausgänge der Mischer M3 und M4 sind mit je einem Eingang des Addierers A verbunden. Der Ausgang des Addierers A ist über den Verstärker V1 mit einem Eingang des Subtrahierers S1 verbunden.

Dem anderen Eingang des Subtrahierers S1 wird das Empfangssignal $F_E$ zugeführt.

Der Oszillator LO ist auf die Mittenfrequenz des Empfangssignals $F_E$ abgestimmt. Das den Mischern M1 und M3 vom Oszillator LO zugeführte Oszillatorsignal ist um 90° gegenüber dem den Mischern M2 und M4 zugeführten Oszillatorsignal phasenverschoben. Das Eingangssignal der Mischer M1 und M2 wird durch Mischung mit den Oszillatorsignalen auf die Zwischenfrequenz Null umgesetzt. Nur die Quadraturkomponenten der im Empfangssignal $F_E$ enthaltenen Störsignale werden durch die Hochpaßfilter HP1 und HP2 durchgelassen und durch Mischen mit den Oszillatorsignalen in den Mischern M3 und M4 wieder in die ursprüngliche Hochfrequenzlage hochgemischt. Die Ausgangssignale der Mischer M3 und M4 werden im Addierer A addiert. Das daraus resultierende Signal entspricht den Störsignalen im Empfangssignal $F_E$. Es wird durch den Verstärker V1 verstärkt und dann durch den Subtrahierer S1 vom Empfangssignal $F_E$ subtrahiert. Der Empfänger enthält also einen Rückkopplungskreis, durch den im eingeschwungenen Zustand die Störsignale aus dem Empfangssignal $F_E$ eliminiert werden.

Daher tritt am Ausgang des Subtrahierers S1 ein Nutzsignal $F_N$ auf, dessen Quadraturkomponenten an den Ausgängen der Mischer M1 und M2 abgegriffen und einer Signalverarbeitungseinrichtung SV zugeführt werden.

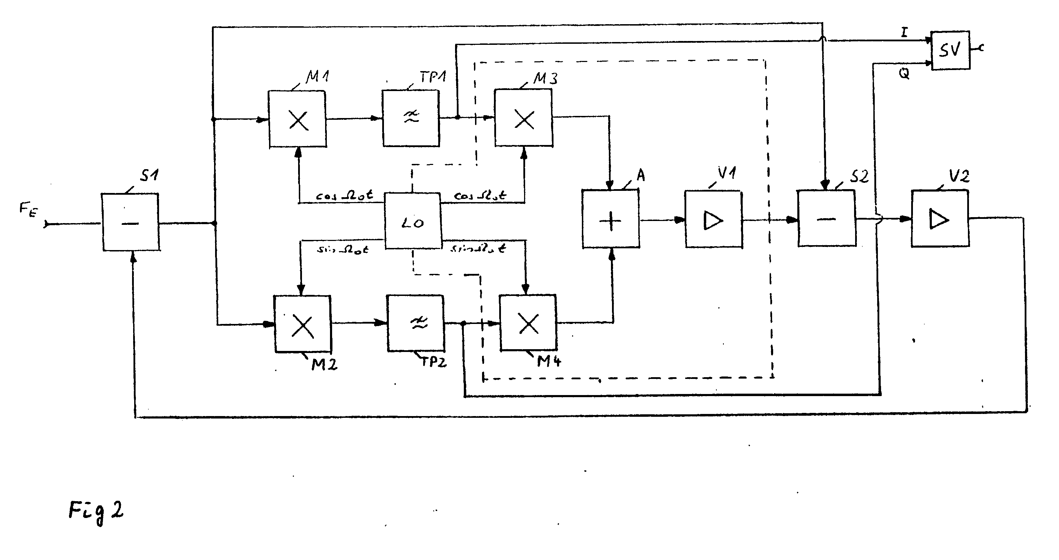

Das zweite Ausführungsbeispiel des Empfängers unterscheidet sich gemäß Fig. 2 von dem Empfänger nach Fig. 1 durch einen weiteren Subtrahierer S2 und Verstärker V2, die hintereinander und zwischen den Ausgang des Verstärkers V1 und den einen Eingang des Subtrahierers S1 geschaltet sind. Ferner ist der Ausgang des Subtrahierers S1 mit einem Eingang des Subtrahierers S2 verbunden. Anstelle der Hochpaßfilter HP1, HP2 sind Tiefpaßfilter TP1, TP2 vorhanden.

Nur die Quadraturkomponenten des im Empfangssignal $F_E$ enthaltenen Nutzsignals werden von den Tiefpaßfiltern TP1, TP2 durchgelassen, durch die Mischer M3 und M4 in die ursprüngliche Hochfrequenzlage hochgemischt, im Addierer A addiert, verstärkt und dem weiteren Subtrahierer S2 zugeführt, der das Nutzsignal vom Eingangssignal der Mischer M1 und M2 subtrahiert. Am Ausgang des weiteren Subtrahierers S2 treten daher nur die im Empfangssignal enthaltenen Störsignale auf. Diese werden durch den weiteren Verstärker V2 verstärkt und dann durch den Subtrahierer S1 vom Empfangssignal $F_E$ subtrahiert. Die Quadraturkomponenten des Nutzsignals $F_N$ werden an den Ausgängen der Tiefpaßfilter TP1, TP2 abgegriffen und einer Signalverarbeitungseinrichtung SV zugeführt.

Bei beiden Ausführungsbeispielen kann durch Einfügen weiterer Schaltungen verschiedener Frequenzgänge, beispielsweise Hoch-, Tief- oder Allpaßfilter, in den Rückkopplungskreis die Selektivität des Empfängers weiter verbessert sein.

Die Signalverarbeitungseinrichtung SV kann in analoger oder digitaler Technik realisiert sein. Sie enthält zumindest einen Demodulator. Abhängig vom benutzten Modulationsverfahren kann sie weitere Schaltungen, wie beispielsweise Umsetzer, Verstärker, etc. enthalten.

Das Hochpaßfilter HP1 und/oder HP2 ist durch ein Tiefpaßfilter realisiert, dessen Ausgang über einen Verstärker mit einem Eingang eines Subtrahierers verbunden ist. Das zu filternde Signal ist ferner direkt dem anderen Eingang des Subtrahierers zugeführt.

Die Kombination aus einem Subtrahierer oder Addierer mit einem nachgeschalteten Verstärker ist durch einen Übertrager mit zwei Primärspulen und einer Sekundärspule realisiert, bei dem durch Wahl der Windungszahlen die benötigte Spannungsverstärkung erreicht ist.

In einem Sende/Empfangsgerät ist der in den beide Figuren gestrichelt umrandete Teil des Empfängers beim Sendebetrieb als Umsetzer verwendbar. In diesem Anwendungsfall ist an den Eingängen der Mischer M3 und M4 und am Ausgang des dem Addierer A nachgeschalteten Verstärkers V1 je ein Sende/Empfangs-Umschalter vorhanden. Beim Senden sind daher die Eingänge der Mischer M3 und M4 mit den Ausgängen eines Quadraturmodulators und der Ausgang des Verstärkers V1 mit dem Eingang einer Sender-Leistungsstufe verbunden. Der Quadraturmodulator erzeugt aus einem Modulationssignal zwei um 90° phasenverschobene Signale, die den Mischern M3, M4 zugeführt sind. Er kann in analoger oder digitaler Technik realisiert sein.

## Patentansprüche

1. Funkempfänger mit zwei Mischern (M1, M2) zum Mischen eines Eingangssignals mit zwei sich um eine Phasenverschiebung von 90° unterscheidenden Oszillatorsignalen, deren Frequenz gleich der Trägerfrequenz des Eingangssignals ist, **dadurch gekennzeichnet,** daß das Empfangssignal ($F_E$) einem Eingang eines Subtrahierers (S1) zugeführt ist, daß den Mischern (M1, M2) Hochpässe (HP1, HP2) und den Hochpässen (HP1, HP2) zwei weitere Mischer (M3, M4) zum Mischen des hochpaßgefilterten Signals mit den sich um eine Phasenverschiebung von 90° unterscheidenden Oszillatorsignalen nachgeschaltet sind, wobei die zwei jeweils mit einem Hochpaßfilter verbundenen Mischer vom gleichen Oszillatorsignal gespeist werden, daß die Ausgangssignale der weiteren Mischer (M3, M4) in einem Addierer (A) addiert und nach Verstärkung in einem Verstärker (V1) dem anderen Eingang des Subtrahierers (S1) zugeführt sind, der sie vom Empfangssignal ($F_E$) subtrahiert, wodurch das Eingangssignal entsteht, und daß die Ausgangssignale der Mischer (M1, M2) einer Signalverarbeitungseinrichtung (SV) zugeführt sind.

2. Funkempfänger mit zwei Mischern (M1, M2) zum Mischen eines Eingangssignals mit zwei sich um eine Phasenverschiebung von 90° unterscheidenden Oszillatorsignalen, deren Frequenz gleich der Trägerfrequenz des Eingangssignals ist und zwei den Mischern nachgeschalteten Tiefpässen (TP1, TP2), dadurch gekennzeichnet, daß das Empfangssignal ($F_E$) einem Eingang eines Subtrahierers (S1) zugeführt ist, daß den Tiefpässen (TP1, TP2) zwei weitere Mischer (M3, M4) zum Mischen des tiefpaßgefilterten Signals mit den sich um eine Phasenverschiebung von 90° unterscheidenden Oszillatorsignalen nachgeschaltet sind, wie A1 daß die Ausgangssignale der weiteren Mischer (M3, M4) in einem Addierer (A) addiert und nach Verstärkung in einem Verstärker (V1) von dem Eingangssignal subtrahiert werden, daß das daraus resultierende Signal nach dessen Verstärkung dem anderen Eingang des Subtrahierers (S1) zugeführt ist, der es vom Empfangssignal ($F_E$) subtrahiert, wodurch das Eingangssignal entsteht, und daß die Ausgangssignale der Tiefpässe (TP1, TP2) einer Signalverarbeitungseinrichtung (SV) zugeführt sind.

3. Empfänger nach Anspruch 1 oder Anspruch 2, dadurch gekennzeichnet, daß die Signalverarbeitungseinrichtung (SV) einen Demodulator enthält und in digitaler und/oder analoger Technik realisiert ist.

4. Empfänger nach einem der vorstehenden Ansprüche, dadurch gekennzeichnet, daß mindestens ein Teil der Addierer und/oder Subtrahierer als Übertrager oder rauscharmer Verstärker realisiert ist.

5. Empfänger nach einem der Ansprüche 2 bis 4 ohne deren Rückbeziehung auf Anspruch 1, dadurch gekennzeichnet, daß er in einem Funksende/empfangsgerät verwendet wird, wobei die Tiefpässe (TP1, TP2), die weiteren Mischer (M3, M4), der diesen nachgeschaltete Addierer (A) und der Verstärker (V1) im Sendebetrieb als Umsetzstufe verwendet sind.

## Claims

1. Radio receiver comprising two mixers (M1, M2) for respectively mixing an input signal with two oscillator signals differing in phase by 90° and having the same frequency as the carrier of the input signal, **characterized in** that the incoming signal ($F_E$) is coupled to one of the inputs of a subtracter (S1), that the mixers (M1, M2) are followed by high-pass filters (HP1, HP2) which, in turn, are followed by two additional mixers (M3, M4) for respectively mixing the high-pass-filtered signal with the oscillator signals differing in phase by 90°, that each of the two mixers connected to the same high-pass filter is supplied with the same oscillator signal, that the outputs from the additional mixers (M3, M4) are added in an adder (A) and, after amplification in an amplifier (V1), are coupled to the other input of the subtracter (S1), which subtracts them from the incoming signal (F$_E$) to form the input signal, and that the outputs from the mixers (M1, M2) are fed to a signal processor (SV).

2. Radio receiver comprising two mixers (M1, M2) for respectively mixing an input signal with two oscillator signals differing in phase by 90° and having the same frequency as the carrier of the input signal, and two low-pass filters (TP1, TP2) following the mixers, characterized in that the incoming signal (F$_E$) is coupled to one of the inputs of a subtracter (S1), that the low-pass filters (TP1, TP2) are followed by two additional mixers (M3, M4) for respectively mixing the low-pass-filtered signal with the oscillator signals differing in phase by 90°, that each of the two mixers connected to the same high-pass filter is supplied with the same oscillator signal, that the outputs from the additional mixers (M3, M4) are added in an adder (A) and, after amplification in an amplifier (V1), are subtracted from the input signal, that the resulting signal is amplified and coupled to the other input of the subtracter (S1), which subtracts it from the incoming signal (F$_E$) to form the input signal, and that the outputs from the low-pass filters (TP1, TP2) are fed to a signal processor (SV).

3. A receiver as claimed in claim 1 or 2, characterized in that the signal processor (SV) contains a demodulator and is implemented in digital and/or analog technology.

4. A receiver as claimed in any one of the preceding claims, characterized in that at least part of the adders and/or subtracters are realized with transformers or low-noise amplifiers.

5. A receiver as claimed in any one of claims 2 to 4 without their dependency on claim 1, characterized in that it is employed in a radio transceiver, with the low-pass filters (TP1, TP2), the additional mixers (M3, M4), the adder (A), and the amplifier (V1) being used as a converter stage during transmission.

**Revendications**

1. Récepteur radio comprenant deux mélangeurs (M1, M2) pour mélanger respectivement un signal d'entrée avec deux signaux d'oscillateur déphasés de 90° ayant la même fréquence que la fréquence porteuse du signal d'entrée, caractérisé en ce que le signal de réception (F$_E$) est appliqué à une entrée d'un soustacteur (S1), en ce que les mélangeurs (M1, M2) sont suivis de filtres passe-haut (HP1, HP2) eux-mêmes suivis de deux mélangeurs (M3, M4) supplémentaires pour respectivement mélanger les signaux issus des filtres passe-haut avec les signaux d'oscillateur déphasés de 90°, où les deux mélangeurs respectivement reliés à un même filtre passe-haut sont alimentés par le même signal d'oscillateur, en ce que les signaux de sortie des mélangeurs (M3, M4) supplémentaires sont additionnés dans un sommateur (A) et après amplification par un amplificateur (V1) sont appliqués à l'autre entrée du soustracteur (S1), qui les soustrait du signal de réception (F$_E$) générant ainsi le signal d'entrée, et en ce que les signaux de sortie des mélangeurs (M1, M2) sont appliqués à un dispositif (SV) de traitement de signal.

2. Récepteur radio comprenant deux mélangeurs (M1, M2) pour le mélange d'un signal d'entrée avec deux signaux d'oscillateur déphasés de 90°, dont la fréquence est égale à la fréquence porteuse du signal d'entrée, les mélangeurs étant suivis de deux filtres passe-bas (TP1, TP2), caractérisé en ce que le signal de réception (FE) est appliqué à une entrée d'un soustracteur (S1), en ce que les filtres passe-bas (TP1, TP2) sont suivis de deux mélangeurs (M3, M4) supplémentaires pour mélanger respectivement les signaux issus des filtres passe-bas avec les signaux d'oscillateur déphasés de 90°, où les deux mélangeurs respectivement reliés à un même filtre passe-haut sont alimentés par le même signal d'oscillateur, en ce que les signaux de sortie des mélangeurs (M3, M4) supplémentaires sont additionnés dans un sommateur (A) et après amplification par un amplificateur (V1) sont soustraits du signal d'entrée, en ce que le signal issu résultant est appliqué après amplification à l'autre entrée du soustracteur (S1) qui le soustrait du signal de réception (F$_E$) pour fournir le signal d'entrée, et en ce que les signaux de sortie des filtres passe-bas (TP1, TP2) sont appliqués à un dispositif (SV) de traitement de signal.

3. Récepteur selon la revendication 1 ou 2, caractérisé en ce que le dispositif (SV) de traitement de signal comprend un démodulateur et en ce qu'il est réalisé dans une technologie numérique et/ou analogique.

4. Récepteur selon l'une des revendications précédentes, caractérisé en ce qu'au moins une partie des sommateurs et/ou soustracteurs est réalisée à l'aide d'un transformateur ou d'un amplificateur faible bruit.

5. Récepteur selon l'une des revendications 2 à 4 sans leur dépendance de la revendication 1, caractérisé en ce qu'il est utilisé dans un appareil émetteur-récepteur, où les filtres passe-bas (TP1, TP2), les mélangeurs (M3,M4) supplémentaires, le sommateur (A) suivant ces derniers et l'amplificateur (V1), sont utilisés en temps qu'étage convertisseur en émission.

Fig 1

EP 0 201 092 B1

Fig 2